# EUROPÄISCHE PATENTANMELDUNG

(11) **EP 4 503 143 A1**
(43) Veröffentlichungstag der Anmeldung: **05.02.2025**
(21) Anmeldenummer: 23189589.7
(22) Anmeldetag: 03.08.2023
(51) Int. Cl.: H01L 31/042, H02S 40/42, H02S 40/44

(54) **NACHRÜSTVORRICHTUNG FÜR EIN PHOTOVOLTAIKMODUL, VERWENDUNGEN DER NACHRÜSTVORRICHTUNG, SYSTEM MIT ZUMINDEST EINEM PHOTOVOLTAIKMODUL UND ZUMINDEST EINER NACHRÜSTVORRICHTUNG, VERWENDUNGEN DES SYSTEMS UND VERFAHREN ZUR MONTAGE EINER NACHRÜSTVORRICHTUNG**

(71) Anmelder: SolarHub AG, 6110 Wolhusen (CH)
(72) Erfinder: BIGLER, Alfred, 6017 Ruswil (CH)
(74) Vertreter: Koelliker, Robert

(57) **Zusammenfassung**

Die vorliegende Erfindung bezieht sich auf eine Nachrüstvorrichtung (10a; 10b) für ein Photovoltaikmodul (12a; 12b), mit zumindest einem Wärmeübergangselement (14a; 14b) zur Aufnahme und/oder Abgabe von thermischer Energie, mit zumindest einer Wärmetauschereinheit (16a; 16b), welche mit dem Wärmeübergangselement (14a; 14b) thermisch gekoppelt ist, und mit einer Verbindungseinheit (18a; 18b) zur Verbindung mit dem Photovoltaikmodul (12a; 12b), wobei die Verbindungseinheit (18a; 18b) dazu ausgebildet ist, das Wärmeübergangselement (14a; 14b) derart an dem Photovoltaikmodul (12a; 12b) zu fixieren, dass es zumindest abschnittsweise in einem unmittelbaren Oberflächenkontakt mit einer äusseren Oberfläche des Photovoltaikmoduls (12a; 12b) steht.

Beansprucht werden Zudem Verwendungen der Nachrüstvorrichtung, ein System mit zumindest einem Photovoltaikmodul und zumindest einer Nachrüstvorrichtung, Verwendungen des Systems sowie ein Verfahren zur Montage einer Nachrüstvorrichtung an einem Photovoltaikmodul.

## Beschreibung

### Stand der Technik

Die Erfindung betrifft eine Nachrüstvorrichtung für ein Photovoltaikmodul nach Anspruch 1, Verwendungen der Nachrüstvorrichtungen nach den Ansprüchen 10 und 11, ein System mit zumindest einem Photovoltaikmodul und zumindest einer Nachrüstvorrichtung nach Anspruch 12, Verwendungen des Systems nach den Ansprüchen 13 und 14 sowie ein Verfahren zur Montage einer Nachrüstvorrichtung an einem Photovoltaikmodul nach Anspruch 15.

Photovoltaikmodule sind aus dem Stand der Technik seit langem bekannt und gewinnen sowohl in der Industrie als auch für Privatverbraucher auf Dachflächen, an Fassaden und in Freiflächenanlagen weiter zunehmend an Bedeutung für die netzgebundene und netzunabhängige Stromerzeugung auf Basis von Sonnenenergie als erneuerbarer Energiequelle. Neben Photovoltaik zählt auch die sogenannte Solarthermie zu den erneuerbaren Energien, welche sich die Sonnenenergie zu Nutze machen. Im Unterschied zur Photovoltaik wird unter Solarthermie jedoch nicht die Stromerzeugung aus Sonnenenergie, sondern die Umwandlung der Sonnenenergie in nutzbare thermische Energie, beispielsweise zur Warmwasser- und/oder Heizwasserbereitung, verstanden. Weiter ist bekannt, dass herkömmliche Photovoltaikmodule bei steigenden Temperaturen erhebliche Leistungsverluste aufweisen, wobei Temperaturen an Solarmodulen und in ihrer unmittelbaren Umgebung 100°C und mehr betragen können. Aus diesem Grund sind in jüngerer Zeit auch sogenannte Hybridmodule am Markt erhältlich, welche auch als PVT-Module bezeichnet werden, wobei PV für Photovoltaik und T für Thermie stehen. Derartige Hybridmodule umfassen Solarzellen und einen Wärmetauscher, die zusammen in einem Modul vereint sind. Die Verbindung von Photovoltaik und Solarthermie wird in der Fachsprache auch als Photothermie bezeichnet. Der Wärmetauscher in Hybridmodulen dient hierbei zur Kühlung der Solarzellen und ist unmittelbar angrenzend an diese angeordnet. Zudem kann die über den Wärmetauscher eines Hybridmoduls abgeführte thermische Energie zugleich auch weiter genutzt werden. Nachteilig an derartigen Hybridmodulen ist jedoch ihr relativ hoher Preis im Vergleich zu herkömmlichen Photovoltaikmodulen, sowie die fehlende Möglichkeit eines Einsatzes in Kombination mit bereits installierten Photovoltaikmodulen bestehender Photovoltaikanlagen sowie die fehlende Möglichkeit eines Einsatzes in Kombination mit konventionellen Photovoltaikmodulen, welche als Massenware hergestellt und nicht zur Photothermie geeignet sind. Laut Angaben des Branchenverbands Solarpower Europe, wurden allein in Europa nur im Jahr 2022, zusätzlich zu bereits bestehenden Photovoltaikanlagen, neue Photovoltaikanlagen mit einer Gesamtleistung von 41 Gigawatt installiert, wobei anzunehmen ist, dass auch diese zu einem weit überwiegenden Anteil aus herkömmlichen Photovoltaikmodulen aufgebaut sind. Allein unter Gesichtspunkten der Wirtschaftlichkeit und Nachhaltigkeit wäre aus kaum vertretbar, alle oder wenigstens einen Grossteil dieser bereits installierten und noch funktionstüchtigen Photovoltaikmodule durch neue Hybridmodule zu ersetzten. In Anbetracht der erheblichen Effizienzsteigerungen, die bei Photothermie gegenüber reiner Photovoltaik, aufgrund der verbesserten Leistungsausbeute der Photovoltaikzellen durch deren Kühlung, sowie aufgrund der zusätzlichen Gewinnung thermischer Energie, erreicht werden können, wäre es andererseits jedoch wünschenswert, möglichst viele bereits installierte herkömmliche Photovoltaikmodule für einen Photothermie-Betrieb nachrüsten zu können, ohne diese komplett ersetzen zu müssen. Ein weiterer wünschenswertet Aspekt zur Effizienzsteigerung herkömmlicher Photovoltaikmodule ist eine Möglichkeit diese beheizen zu können, um sie von Schnee und/oder Eis zu befreien, damit im Winter bei Sonnenschein überhaupt Energie gewonnen werden kann. Hierdurch könnte der Anteil der erneuerbaren Energien zur Deckung des gesamten Energiebedarfs, auch unter Berücksichtigung begrenzter Ressourcen an Rohstoffen und begrenzter Flächen, die für die Nutzung von Sonnenenergie geeignet sind, signifikant weiter gesteigert werden. Vor diesem Hintergrund fehlt es im Stand der Technik bislang an einer Nachrüstvorrichtung für ein Photovoltaikmodul, welche ein einfaches Nachrüsten von reiner Photovoltaik auf Photothermie ermöglicht. Zudem besteht auch der Bedarf an einer kostengünstigen Alternative zu bisher bekannten Hybridmodulen in Form eines Systems aus zumindest einem Photovoltaikmodul mit zumindest einer solchen Nachrüstvorrichtung.

Die Aufgabe der Erfindung besteht insbesondere darin, eine Nachrüstvorrichtung für ein Photovoltaikmodul bereitzustellen, welche die oben genannten Nachteile im Stand der Technik überwindet. Die Aufgabe wird erfindungsgemäss durch die Merkmale der Ansprüche 1 und 10 bis 15 gelöst, während vorteilhafte Ausgestaltungen und Weiterbildungen der Erfindung den Unteransprüchen entnommen werden können.

### Beschreibung der Erfindung

Die Erfindung bezieht sich auf eine Nachrüstvorrichtung für ein Photovoltaikmodul, mit zumindest einem Wärmeübergangselement zur Aufnahme und/oder Abgabe von thermischer Energie, mit zumindest einer Wärmetauschereinheit, welche mit dem Wärmeübergangselement thermisch gekoppelt ist, und mit einer Verbindungseinheit zur Verbindung mit dem Photovoltaikmodul, wobei die Verbindungseinheit dazu ausgebildet ist, das Wärmeübergangselement derart an dem Photovoltaikmodul zu fixieren, dass es zumindest abschnittsweise in einem unmittelbaren Oberflächenkontakt mit einer äusseren Oberfläche des Photovoltaikmoduls steht.

Durch eine derartige Ausgestaltung kann vorteilhaft eine Nachrüstvorrichtung zum Nachrüsten herkömmlicher Photovoltaikmodule für einem Photothermie-Betrieb bereitgestellt werden, welche die Nachteile im Stand der Technik überwindet. Somit kann weiter vorteilhaft ein effizienterer Betrieb von herkömmlichen Photovoltaikmodulen sowie eine zusätzliche Gewinnung und Nutzbarmachung von thermischer Energie ermöglicht werden. Zudem kann bei Bedarf vorteilhaft auch eine Beheizung des Photovoltaikmoduls mittels der Nachrüstvorrichtung ermöglicht werden. Des Weiteren kann vorteilhaft eine besonders einfache und schnelle Anbringung der Nachrüstvorrichtung an dem Photovoltaikmodul mittels der Verbindungseinheit ermöglicht werden. Ferner kann vorteilhaft ein hohes Mass an Flexibilität erreicht werden, da die Nachrüstvorrichtung an verschiedene Typen von Photovoltaikmodulen angepasst und an diesen installiert werden kann. Weiterhin kann vorteilhaft eine kostengünstige Alternativ zu bisher bekannten Hybridmodulen bereitgestellt werden.

Die Nachrüstvorrichtung ist zu einer Nachrüstung eines Photovoltaikmoduls vorgesehen und dabei nicht grundsätzlich auf einen Einsatz mit bestimmten Typen von Photovoltaikmodulen beschränkt. Insbesondere können Photovoltaikmodule mit unterschiedlichem Aufbau, insbesondere mit allen gängigen Typen von Solarzellen und mit einer unterschiedlichen Anzahl und/oder Anordnung der Solarzellen, sowie mit verschiedensten Abmessungen mittels der Nachrüstvorrichtung nachgerüstet werden. Die Nachrüstvorrichtung ist an alle gängigen Photovoltaikmodule mit Standardabmessungen, die dem Fachmann bekannt sind, anpassbar und anbringbar. Allenfalls bei Photovoltaikmodulen mit sehr kleinen Abmessungen, deren Gesamtlänge und/oder Gesamtbreite 500 mm unterschreiten, können sich Einschränkungen im Hinblick auf einen Einsatz der Nachrüstvorrichtung ergeben. In einem montierten Zustand der Nachrüstvorrichtung, das heisst bei hergestellter Verbindung mit dem Photovoltaikmodul, ist die Nachrüstvorrichtung dazu vorgesehen, zur Kühlung des Photovoltaikmoduls thermische Energie von dem Photovoltaikmodul abzuführen und diese thermische Energie zumindest teilweise nutzbar zu machen und/oder das Photovoltaikmodul zu beheizen. Aufgrund der kompakten Abmessungen der Nachrüstvorrichtung ist eine Installation des Photovoltaikmoduls auf Dachflächen und/oder Fassaden und/oder in Freiflächenanlagen auch mit einer damit verbundenen Nachrüstvorrichtung weiterhin wie gewohnt möglich.

Das Wärmeübergangselement ist zur Aufnahme und/oder Abgabe von thermischer Energie vorgesehen, insbesondere zum Transport von thermischer Energie von zumindest einem ersten Objekt an zumindest ein zweites Objekt, wobei die thermische Energie insbesondere in Form von Wärmestrahlung und/oder Wärmkonvektion und/oder Wärmeleitung transportiert werden kann. In einer ersten Betriebsart der Nachrüstvorrichtung ist das Wärmeübergangselement dazu vorgesehen, thermische Energie von dem Photovoltaikmodul und/oder aus der Umgebung des Photovoltaikmoduls aufzunehmen und diese an die zumindest eine Wärmetauschereinheit abzugeben. In einer zweiten Betriebsart der Nachrüstvorrichtung ist das Wärmeübergangselement dazu vorgesehen, thermische Energie von der zumindest einen Wärmetauschereinheit aufzunehmen und an das Photovoltaikmodul abzugeben. Das Wärmeübergangselement weist hierzu beispielsweise eine Wärmeleitfähigkeit von zumindest 15 W/(m*K), insbesondere von zumindest 50 W/(m*K), vorteilhaft von zumindest 100 W/(m*K), besonders vorteilhaft von zumindest 150 W/(m*K), vorzugsweise von zumindest 200 W/(m*K), bevorzugt von zumindest 250 W/(m*K), besonders bevorzugt von zumindest 300 W/(m*K) und am meisten bevorzugt von zumindest 400 W/(m*K) auf. Das Wärmeübergangselement ist hierzu aus einem oder mehreren Materialien mit entsprechender Wärmeleitfähigkeit ausgebildet. Als geeignete Materialien für das Wärmeübergangselement kommen, ohne darauf beschränkt zu sein, beispielsweise Metalle mit einer hohen Wärmeleitfähigkeit, wie Silber und/oder Kupfer und/oder Aluminium und/oder dergleichen, sowie Legierungen dieser Metalle in Frage. Denkbar ist auch, dass das Wärmeübergangselement eine Beschichtung zur Erhöhung und/oder Aufrechterhaltung der Wärmleitfähigkeit aufweist. Geeignete Beschichtungen sind dem Fachmann, beispielsweise in Form von Einbrennbeschichtungen auf Phenolbasis oder dergleichen, bekannt. Denkbar ist auch, dass Abschnitte des Wärmeübergangselements mit einer Substanz, beispielsweise Wärmeleitpaste oder dergleichen, versehen sind, um die Wärmeleitfähigkeit und/oder die Kontaktfläche zwischen dem Wärmeübergangselement und der äusseren Oberfläche des Photovoltaikmoduls zu erhöhen. Vorzugsweise ist das Wärmeübergangselement flächig ausgebildet und weist insbesondere eine grösste Längenerstreckung und eine grösste Breitenerstreckung auf, die jeweils zumindest um einen Faktor 10 grösser sind als eine grösste Tiefenerstreckung des Wärmeübergangselements. Vorzugsweise sind Oberflächen des Wärmeübergangselements makroskopisch glatt ausgebildet und weisen insbesondere keine mit bloßem Auge sichtbaren Unebenheiten auf. Beispielsweise könnte das Wärmeübergangselement aus einem Blech ausgebildet sein. Denkbar ist jedoch auch, dass das Wärmeübergangselement einen oder mehrere strukturierte Oberflächenabschnitte aufweist, die an eine Oberflächenstruktur der Abschnitte der äusseren Oberfläche des Photovoltaikmoduls, welche in dem montierten Zustand mit dem Wärmübergangselement in Kontakt stehen, angepasst sind. Beispielsweise könnte das Wärmeübergangselement einen oder mehrere Oberflächenabschnitte aufweisen, die gewellt oder geriffelt sind. Denkbar wäre beispielsweise auch, dass das Wärmeübergangselement aus einem Streckmetall ausgebildet ist. Vorzugsweise ist das Wärmübergangselement elastisch ausgebildet. Unter «elastisch» soll in diesem Zusammenhang verstanden werden, dass ein Element Materialeigenschaft aufweist, welche zulassen, dass das Element nach einer Verformung durch eine äussere Kraft selbständig wieder in seine Ausgangsform zurückkehrt. Denkbar ist jedoch auch, dass das Wärmeübergangselement plastisch ausgebildet ist. Unter «plastisch» soll in diesem Zusammenhang verstanden werden, dass ein Element Materialeigenschaft aufweist, welche eine dauerhafte Verformung durch eine äussere Kraft zulassen. Beispielsweise ist denkbar, dass ein plastisch ausgebildetes Wärmeübergangselement abschnittsweise an die äussere Oberfläche des Photovoltaikmoduls anpassbar ist, insbesondere um eine Kontaktfläche zu erhöhen. Vorzugsweise weist das Wärmeübergangselement zumindest eine Aussparung auf, die dazu ausgelegt ist, in dem montierten Zustand, in welchem das Wärmeübergangselement an dem Photovoltaikmodul fixiert ist, einen Bereich elektrischer Anschlüsse des Photovoltaikmoduls freizuhalten.

Die Wärmetauschereinheit ist zu einer Übertragung von thermischer Energie zwischen dem Wärmeübergangselement und einem Wärmeträgermedium vorgesehen. In der ersten Betriebsart der Nachrüstvorrichtung ist die Wärmetauschereinheit insbesondere dazu vorgesehen, thermische Energie von dem Wärmeübergangselement auf das Wärmeträgermedium zu übertragen. In der zweiten Betriebsart der Nachrüstvorrichtung ist die Wärmetauschereinheit insbesondere dazu vorgesehen, thermische Energie von dem Wärmeträgermedium auf das Wärmeübergangselement zu übertragen. Vorzugsweise ist die Wärmetauschereinheit für einen Einsatz verschiedener Wärmeträgermedien ausgelegt und weist eine entsprechende Materialbeständigkeit auf. Die Wärmetauschereinheit kann neben einem Einsatz mit Wasser als Wärmeträgermedium auch zu einem Einsatz mit anderen Wärmeträgermedien, beispielsweise Alkohol-Wasser-Lösungen und/oder Glykolen und/oder Salz-Wasser-Lösungen und/oder dergleichen ausgebildet sein. Die Wärmetauschereinheit ist für Drücke von zumindest 0.5 bar über Atmosphärendruck, insbesondere von zumindest 1.0 bar über Atmosphärendruck, vorteilhaft von zumindest 1.5 bar über Atmosphärendruck, besonders vorteilhaft von zumindest 2.5 bar über Atmosphärendruck, vorzugsweise von zumindest 5.0 bar über Atmosphärendruck, bevorzugt von zumindest 7.5 bar über Atmosphärendruck und besonders bevorzugt von zumindest 10.0 bar über Atmosphärendruck ausgelegt. Vorzugsweise ist die Wärmetauschereinheit dazu ausgelegt, Phasenübergängen des Wärmeträgermediums beim Durchströmen der Wärmetauschereinheit, insbesondere von flüssig zu gasförmig, standzuhalten. In dem montierten Zustand der Nachrüstvorrichtung ist die Wärmetauschereinheit mit dem Wärmeübergangselement thermisch gekoppelt. Die Wärmetauschereinheit könnte mittelbar, beispielsweise über ein weiteres Element oder über eine Luftschicht, thermisch mit dem Wärmeübergangselement gekoppelt sein, um eine Übertragung von thermischer Energie zwischen dem Wärmeübergangselement und dem Wärmeträgermedium zu gewährleisten. Vorzugsweise ist die Wärmetauschereinheit unmittelbar thermisch mit dem Wärmeübergangselement gekoppelt und steht in dem montierten Zustand zumindest abschnittsweise in unmittelbarem Oberflächenkontakt mit dem Wärmübergangselement, um eine Übertragung von thermischer Energie zwischen dem Wärmeübergangselement und dem Wärmeträgermedium zu gewährleisten.

Die Verbindungseinheit ist dazu ausgebildet, das Wärmeübergangselement derart an dem Photovoltaikmodul zu fixieren, dass es zumindest abschnittsweise in einem unmittelbaren Oberflächenkontakt mit einer äusseren Oberfläche des Photovoltaikmoduls steht. Unter der «äusseren Oberfläche» des Photovoltaikmoduls ist dabei die Oberfläche des Photovoltaikmoduls, welche in einem betriebsfähigen Zustand des Photovoltaikmoduls von aussen sichtbar ist, zu verstehen. Herkömmlich Photovoltaikmodule weisen eine Mehrzahl von Solarzellen auf, die derart in einen Rahmen des Photovoltaikmoduls eingefasst sind, dass sie zu einer Oberseite des Photovoltaikmoduls hin ausgerichtet sind. Die Solarzellen können zur Oberseite durch eine Glasplatte oder durch eine transparente Folie abgedeckt sein. Zu einer der Oberseite gegenüberliegenden Unterseite des Photovoltaikmoduls hin sind die Solarzellen in der Regel durch eine Schicht aus Kunststoff, beispielsweise Polyvinylchlorid (PVC), abgedeckt, welche die Unterseite des Photovoltaikmoduls ausbildet. Vorzugsweise ist die Verbindungseinheit dazu ausgebildet, das Wärmeübergangselement derart an dem Photovoltaikmodul zu fixieren, dass es zumindest abschnittsweise in einem unmittelbaren Oberflächenkontakt mit einem Abschnitt der äusseren Oberfläche an der Unterseite des Photovoltaikmoduls steht. Vorzugsweise ist die Verbindungseinheit dazu ausgebildet, zur Herstellung der Verbindung mit dem Photovoltaikmodul, mit dem Rahmen des Photovoltaikmoduls zusammenzuwirken. Denkbar ist zum Beispiel, dass die Verbindungseinheit Elemente aufweist, welche zur Verbindung mit dem Rahmen des Photovoltaikmoduls vorgesehen sind. Beispielsweise und ohne darauf beschränkt zu sein, können Elemente der Verbindungseinheit dazu vorgesehen sein, mit dem Rahmen verbunden, beispielsweise verschraubt und/oder verklebt und/oder verschweisst, zu werden und/oder zwischen Abschnitten des Rahmens eingespannt zu werden und/oder Abschnitte des Rahmens form- und/oder kraftschlüssig zu umgreifen.

In dem vorliegenden Dokument dienen bestimmten Ausdrücken vorangestellte Zahlwörter, wie beispielsweise «erste/r/s» und «zweite/r/s», lediglich zu einer Unterscheidung von Objekten und/oder einer Zuordnung zwischen Objekten untereinander und implizieren keine vorhandene Gesamtanzahl und/oder Rangfolge der Objekte.

Unter «vorgesehen» soll in dem vorliegenden Dokument speziell ausgelegt und/oder ausgestattet verstanden werden.

Der Ausdruck «zumindest im Wesentlichen» meint in dem vorliegenden Dokument eine Übereinstimmung im Rahmen fachüblicher technischer Toleranzgrenzen auf dem Gebiet der Erfindung.

Die Verbindungseinheit könnte zu einer unlösbaren Verbindung mit dem Photovoltaikmodul, insbesondere zu einer stoffschlüssigen Verbindung, beispielsweise einer Schweissverbindung oder Klebverbindung oder dergleichen, ausgebildet sein. In einer vorteilhaften Ausgestaltung der Erfindung wird jedoch vorgeschlagen, dass die Verbindungseinheit zu einer zerstörungsfrei lösbaren Verbindung mit dem Photovoltaikmodul ausgebildet ist. Hierdurch kann vorteilhaft eine Montage und Demontage erleichtert werden. Ferner kann vorteilhaft ein besonders nachhaltiger und ressourceneffizienter Einsatz der Nachrüstvorrichtung ermöglicht werden, beispielsweise indem diese nach dem Ende der Lebensdauer eines bestimmten Photovoltaikmoduls leicht abmontiert und mit einem anderen Photovoltaikmodul weiterverwendet werden kann. Unter einer «zerstörungsfrei lösbaren» Verbindung soll in diesem Dokument eine Verbindung verstanden werden, welche, mit oder ohne einen Einsatz von Werkzeug lösbar ist, ohne dabei eine Zerstörung von an der Verbindung beteiligten Komponenten zu bewirken. Eine «Zerstörung» meint in diesem Zusammenhang einen Vorgang, durch welchen Bauteil für seinen eigentlichen Zweck unbrauchbar wird, schliesst jedoch keine üblichen Gebrauchs- und/oder Verschleissprozesse mit ein. Die Verbindungseinheit kann beispielsweise zu einer zerstörungsfrei lösbaren magnetischen Verbindung mit dem Photovoltaikmodul ausgebildet sein. Die Verbindungseinheit ist vorzugsweise zu einer zerstörungsfrei lösbaren form- und/oder kraftschlüssigen Verbindung ausgebildet. Beispielsweise und ohne darauf beschränkt zu sein, kann die Verbindungseinheit zu einer zerstörungsfrei lösbaren form- und/oder kraftschlüssige Verbindung in Form einer Schraub- und/oder Steck- und/oder Klemm- und/oder Press- und/oder Rastverbindung und/oder einer Kombination dieser Verbindungstypen ausgebildet sein.

Zudem wird vorgeschlagen, dass das Wärmeübergangselement Abmessungen aufweist, die so gewählt sind, dass das Wärmeübergangselement in einem montierten Zustand, in welchem es an dem Photovoltaikmodul fixiert ist, zumindest 25 % der äusseren Oberfläche des Photovoltaikmoduls abdeckt. Durch eine derartige Ausgestaltung kann vorteilhaft eine effiziente Kühlung und Gewinnung von thermischer Energie und/oder eine effiziente Beheizung des Photovoltaikmoduls ermöglicht werden. Insbesondere weist das Wärmeübergangselement Abmessungen auf, die so gewählt sind, dass das Wärmeübergangselement in dem montierten Zustand, in welchem es an dem Photovoltaikmodul fixiert ist, zumindest 30 %, vorteilhaft zumindest 35 %, vorzugsweise zumindest 40 %, bevorzugt zumindest 45 % und besonders bevorzugt zumindest 50 % der äusseren Oberfläche des Photovoltaikmoduls abdeckt. Bevorzugt weist das Wärmeübergangselement Abmessungen auf, die so gewählt sind, dass das Wärmeübergangselement in dem montierten Zustand, in welchem es an dem Photovoltaikmodul fixiert ist, zumindest die äussere Oberfläche der Unterseite des Photovoltaikmoduls zu wenigstens einem Großteil von zumindest 85 % abdeckt.

Die Wärmetauschereinheit könnte stoffschlüssig mit dem Wärmeübergangselement verbunden, beispielsweise mit diesem verschweisst oder verklebt, sein. In einer vorteilhaften Ausgestaltung der Erfindung wird jedoch vorgeschlagen, dass die Wärmetauschereinheit mittels der Verbindungseinheit, insbesondere zerstörungsfrei lösbar, an dem Wärmeübergangselement fixiert ist. Hierdurch kann vorteilhaft eine Material- und Montageffizienz verbessert werden. Zudem kann im Bedarfsfall ein einfacher Austausch der Wärmetauschereinheit und/oder des Wärmeübergangselements ermöglicht werden. Vorzugsweise ist die Wärmetauschereinheit mittels der Verbindungseinheit derart an dem Wärmeübergangselement fixiert, dass die Wärmetauschereinheit zumindest abschnittsweise in unmittelbaren Oberflächenkontakt mit dem Wärmeübergangselement steht.

Ferner wird vorgeschlagen, dass die Wärmetauschereinheit eine Gehäuseeinheit aufweist, welche zumindest ein erstes Gehäuseelement, ein erstes Anschlusselement und zumindest ein zweites Anschlusselement umfasst, wobei ein Strömungskanal für ein Wärmeträgermedium, welcher die Anschlusselemente strömungstechnisch miteinander verbindet, zumindest teilweise durch das erste Gehäuseelement ausgebildet ist. Durch eine derartige Ausgestaltung kann vorteilhaft ein einfacher Aufbau der Wärmetauschereinheit erreicht werden. Vorzugsweise ist die Gehäuseeinheit wenigstens zu einem Grossteil, aus einem oder mehreren Materialien mit einer Wärmeleitfähigkeit von zumindest 15 W/(m*K), insbesondere von zumindest 50 W/(m*K), vorteilhaft von zumindest 100 W/(m*K), besonders vorteilhaft von zumindest 150 W/(m*K), vorzugsweise von zumindest 200 W/(m*K), bevorzugt von zumindest 250 W/(m*K), besonders bevorzugt von zumindest 300 W/(m*K) und am meisten bevorzugt von zumindest 400 W/(m*K), ausgebildet. Die Wärmetauschereinheit kann, ohne darauf beschränkt zu sein, beispielsweise Metalle mit einer hohen Wärmeleitfähigkeit, wie Silber und/oder Kupfer und/oder Aluminium und/oder dergleichen, oder Legierungen dieser Metalle umfassen. Beispielsweise können Elemente der Gehäuseeinheit, insbesondere das erste Gehäuseelement, als Aluminium-Druckguss-Teile ausgebildet sein. Die Anschlusselement der Gehäuseeinheit sind zu einem Anschluss von Förderleitungen für das Wärmeträgermedium vorgesehen. Das erste Anschlusselement und das zweite Anschlusselement könnten voneinander verschieden ausgebildet sein. Vorzugsweise sind das erste Anschlusselement und das zweite Anschlusselement zumindest im Wesentlichen identisch zueinander ausgebildet. Hierdurch kann vorteilhaft je nach Bedarf eines der Anschlusselemente für die Zufuhr und das jeweils andere für die Abfuhr von Wärmeträgermedium genutzt werden. Das erste Anschlusselement und das zweite Anschlusselement könnten auf verschiedenen, insbesondere gegenüberliegenden, Seiten der Gehäuseeinheit angeordnet sein. Denkbar ist auch, dass das erste Anschlusselement und das zweite Anschlusselement auf derselben Seite, beispielsweise auf der Unterseite, der Gehäuseeinheit angeordnet sind. Vorzugsweise sind die Anschlusselemente zu einem Anschluss von Förderleitungen, beispielsweise Kupferrohrleitungen, ausgelegt, die der Norm EN ISO 6708 aus dem Heizungsbau entsprechen. Die Anschlusselemente können zum Anschluss der Förderleitungen mittels einer stoffschlüssigen Verbindung, beispielsweise zum Löten und/oder Schweissen und/oder Kleben, ausgelegt sein. Vorzugsweise sind die Anschlusselemente zum Anschluss der Förderleitungen mittels einer form- und/oder kraftschlüssigen Verbindung, beispielsweise zum Pressen und/oder Klemmen und/oder Verschrauben und/oder dergleichen ausgelegt. Zur Herstellung einer form- und/oder kraftschlüssigen Verbindung mit einer Förderleitung können die Anschlusselemente, entsprechende Gewinde, insbesondere Innen- und/oder Aussengewinde, und/oder entsprechende Dichtflächen aufweisen. Alternativ oder zusätzlich ist zum Anschluss von Förderleitungen an die Anschlusselemente ein Einsatz zusätzlicher Elemente, wie beispielsweise von Flanschen und/oder Schlauchschellen und/oder Dichtelementen und/oder dergleichen, denkbar. Die Anschlusselemente können auch Ventile umfassen. Die Gehäuseeinheit kann neben dem ersten Anschlusselement und dem zweiten Anschlusselement weitere Anschlusselemente umfassen. Der Strömungskanal erstreckt innerhalb der Gehäuseeinheit ausgehend von dem ersten Anschlusselement bis zu dem zweiten Anschlusselement, wobei der Strömungskanal zwischen den Anschlusselementen einen beliebigen Verlauf, beispielsweise einen mäanderförmigen oder spiralförmigen oder einem anderen dem Fachmann als sinnvoll erscheinenden Verlauf, aufweisen kann. Der Strömungskanal kann entlang seines Verlaufs einen konstanten oder variablen Querschnitt aufweisen, welcher beispielsweise eine ovale, insbesondere kreisförmige, oder eckige Kontur oder eine Kontur aus einer Kombination von geraden und abgerundeten Abschnitten aufweisen kann.

In einer vorteilhaften Ausgestaltung wird vorgeschlagen, dass die Gehäuseeinheit ein zweites Gehäuseelement aufweist, wobei der Strömungskanal durch das erste Gehäuseelement und das zweite Gehäuseelement begrenzt ist und das zweite Gehäuseelement zur thermischen Kopplung zumindest abschnittsweise in einem unmittelbaren Oberflächenkontakt mit dem Wärmeübergangselement steht. Durch eine derartige Ausgestaltung kann vorteilhaft ein guter Wärmeübergang zwischen dem Wärmeübergangselement und der Wärmetauschereinheit sichergestellt werden. Zudem kann vorteilhaft eine einfache Montage der Wärmetauschereinheit an dem Wärmeübergangselement erreicht werden. Vorzugsweise weist die Wärmetauschereinheit zumindest ein Dichtelement auf, welches zwischen dem ersten Gehäuseelement und dem zweiten Gehäuseelement angeordnet ist, beispielsweise einen O-Ring oder dergleichen.

In einer alternativen vorteilhaften Ausgestaltung der Erfindung wird vorgeschlagen, dass der Strömungskanal durch das erste Gehäuseelement und das Wärmübergangselement begrenzt ist. Durch eine derartige Ausgestaltung kann ein besonders einfacher und kompakter Aufbau erreicht werden. Zudem kann vorteilhaft eine Wärmeübertragung optimiert werden, da ein direkter Kontakt zwischen Wärmeträgermedium und Wärmeübergangselement besteht, wenn der Strömungskanal durch das Gehäuseelement und das Wärmübergangselement begrenzt ist. Vorzugsweise weist die Nachrüstvorrichtung in dieser Ausgestaltung ein Dichtelement auf, welches in dem montierten Zustand zwischen dem ersten Gehäuseelement und dem Wärmeübergangselement angeordnet ist, um in einem Betrieb einen Austritt von Wärmeträgermedium zu verhindern.

Weiterhin wird vorgeschlagen, dass die Nachrüstvorrichtung eine weitere Wärmetauschereinheit aufweist, welche zumindest im Wesentlichen identisch zu der Wärmetauschereinheit ausgebildet und mit dem Wärmeübergangselement thermisch gekoppelt ist. Hierdurch kann vorteilhaft ein besonders hohes Mass an Flexibilität erreicht werden. Insbesondere kann eine Menge an thermischer Energie die mittels der Nachrüstvorrichtung gewonnen werden kann, leicht an einen individuellen Bedarf angepasst werden. Die Nachrüstvorrichtung kann neben der Wärmetäuschereinheit und der weiteren Wärmetauschereinheit eine beliebige Anzahl zusätzlicher weiterer Wärmetauschereinheit aufweisen, welche jeweils mit dem Wärmeübergangselement thermisch gekoppelt sind. Die Wärmetauschereinheit und die weiter Wärmetauschereinheit könnten hydraulisch parallel angeordnet und zu einem voneinander unabhängigen Betrieb ausgelegt sein. In einer vorteilhaften Ausgestaltung wird jedoch vorgeschlagen, dass die Wärmetauschereinheit und die weitere Wärmetauschereinheit miteinander hydraulisch in Reihe geschaltet sind. Hierdurch kann vorteilhaft eine Montage erleichtert werden. Es kann vorteilhaft eine Menge an thermischer Energie, die durch die Wärmetauschereinheit zu- oder abgeführt werden kann, erhöht werden, ohne dass hierzu zusätzliche Förderleitungen vorgesehen werden müssen, wenn die Wärmetauschereinheit und die weitere Wärmetauschereinheit miteinander hydraulisch in Reihe geschaltet sind.

Die Erfindung betrifft ausserdem die Verwendung einer Nachrüstvorrichtung nach einer der vorhergehend beschriebenen Ausgestaltungen zur Kühlung eines Photovoltaikmoduls und zur Gewinnung von thermischer Energie. Durch eine derartige Verwendung der Nachrüstvorrichtung kann vorteilhaft eine besonders effiziente Nutzung des Photovoltaikmoduls ermöglicht werden. Einerseits können durch Kühlung des Photovoltaikmoduls Nennleistungsverluste aufgrund von Überhitzung vermieden werden. Zudem kann unter Verwendung der Nachrüstvorrichtung vorteilhaft zusätzlich thermische Energie gewonnen und nutzbar gemacht werden.

Zudem betrifft die Erfindung auch die Verwendung einer Nachrüstvorrichtung nach einer der vorhergehend beschriebenen Ausgestaltungen zur Beheizung eines Photovoltaikmoduls. Hierdurch kann vorteilhaft eine effiziente Nutzung des Photovoltaikmoduls auch bei kalten Aussentemperaturen ermöglicht werden. Beispielsweise kann die Oberseite des Photovoltaikmoduls im Winter durch eine Schnee- und/oder Eisschicht bedeckt sein und mittels der Nachrüstvorrichtung abgetaut werden, damit die auch im Winter Sonnenstrahlen auf die Solarzellen eintreffen und die zur Verfügung stehende Sonnenenergie gut genutzt werden kann. Zur Beheizung des Photovoltaikmoduls kann die Wärmetauschereinheit über eine Förderleitung mit einer Wärmequelle, beispielsweise einer Heizungsanlage oder einer Wärmepumpe oder dergleichen, verbunden werden, welche das Wärmeträgermedium vor Einspeisung in die Wärmetauschereinheit auf die erforderliche Temperatur aufheizt.

Die Erfindung betrifft ferner ein System mit zumindest einem Photovoltaikmodul und zumindest einer Nachrüstvorrichtung nach einer der vorhergehend beschriebenen Ausgestaltungen, wobei die Nachrüstvorrichtung mit dem Photovoltaikmodul verbunden ist. Ein derartiges System stellt vorteilhaft eine kostengünstige Alternative zu bisher am Markt erhältlichen Hybridmodulen dar. Das System kann genau ein Photovoltaikmodul mit genau einer Nachrüstvorrichtung umfassen. Ebenso kann das System auch genau ein Photovoltaikmodul mit einer beliebigen Anzahl von Nachrüstvorrichtungen, die jeweils mit dem Photovoltaikmodul verbunden sind, umfassen. Das System kann auch eine beliebige Anzahl von Photovoltaikmodulen umfassen, wobei jedes der Photovoltaikmodule mit jeweils einer oder mehreren Nachrüstvorrichtungen des Systems verbunden sein kann. Das zumindest eine Photovoltaikmodul des Systems kann zusammen mit der zumindest einen Nachrüstvorrichtung auf Dachflächen und/oder Fassaden und/oder in Freiflächenanlagen installiert werden, wobei zur Anbringung des Systems fachübliche Installationsarten, die bei der Installation herkömmlicher Photovoltaikanlagen zum Einsatz kommen, verwendet werden können.

Ein weiterer Aspekt der vorliegenden Erfindung ist die Verwendung des vorhergehend beschriebenen Systems zur Warmwasser- und/oder Heizwasserbereitung mittels thermischer Energie, welche durch die Nachrüstvorrichtung gewonnen wird. Durch eine derartige Verwendung des Systems kann vorteilhaft eine Warmwasser- und/oder Heizwasserbedarf mit einfachen technischen Mitteln anteilig oder vollständig durch erneuerbare Energien gedeckt werden. Das System kann hierzu über eine mit der Wärmetauschereinheit verbundene Förderleitung beispielsweise mit einem Warmwasserspeicher und/oder mit einer Heizungsanlage und/oder mit einer Wärmepumpe und/oder dergleichen verbunden werden.

In einem weiteren Aspekt der vorliegenden Erfindung wird die Verwendung des vorhergehend beschriebenen Systems zur elektrischen Energieerzeugung mittels thermischer Energie, welche durch die Nachrüstvorrichtung gewonnen wird, vorgeschlagen. Durch eine derartige Verwendung des Systems kann vorteilhaft eine Menge an elektrischer Energie, welche bereits über das Photovoltaikmodul erzeugt wird, weiter erhöht werden. Das System kann hierzu beispielsweise mit einer Turbine und einem Generator verbunden werden. Diese Verwendung des Systems erweist sich insbesondere als vorteilhaft um eine Energieeffizienz weiter zu steigern, insbesondere wenn ein Bedarf an thermischer Energie, beispielsweise zur Warmwasser- und/oder Heizwasserbereitung, gering ist und/oder bereits über andere erneuerbare Energiequellen gedeckt werden kann.

Die Erfindung betrifft ferner ein Verfahren zur Montage einer Nachrüstvorrichtung, insbesondere nach einer vorhergehend beschriebenen Ausgestaltungen, an einem Photovoltaikmodul, wobei zumindest ein Wärmeübergangselement zur Aufnahme und/oder Abgabe von thermischer Energie derart an dem Photovoltaikmodul fixiert wird, dass das Wärmeübergangselement zumindest abschnittsweise in einem unmittelbaren Oberflächenkontakt mit einer äusseren Oberfläche des Photovoltaikmoduls steht und wobei zumindest eine Wärmetauschereinheit mit dem Wärmeübergangselement thermisch gekoppelt wird. Mittels des Verfahrens kann vorteilhaft eine einfache und zuverlässige Montage der Nachrüstvorrichtung an dem Photovoltaikmodul ermöglicht werden. Das Verfahren umfasst zumindest zwei Verfahrensschritte. Vorzugsweise wird in einem ersten Verfahrensschritt des Verfahrens das Wärmeübergangselement derart an dem Photovoltaikmodul fixiert, dass es zumindest abschnittsweise in einem unmittelbaren Oberflächenkontakt mit der äusseren Oberfläche des Photovoltaikmoduls steht. In einem zweiten Verfahrensschritt des Verfahrens wird die Wärmetauschereinheit mit dem Wärmeübergangselement thermisch und insbesondere auch mechanisch gekoppelt. Es ist jedoch auch denkbar, dass das Verfahren durchgeführt wird, indem zunächst die Wärmetauschereinheit mit dem Wärmeübergangselement verbunden und thermisch gekoppelt wird und anschliessend das Wärmeübergangselement derart an dem Photovoltaikmodul fixiert wird, dass es zumindest abschnittsweise in einem unmittelbaren Oberflächenkontakt mit der äusseren Oberfläche des Photovoltaikmoduls steht. Das Verfahren kann zudem einen oder mehrere Vorbereitungs- und/oder Nachbereitungsschritte umfassen, in welchen beispielsweise die Wärmetauschereinheit aus einzelnen Gehäuseelementen zusammengesetzt und/oder die Anschlusselemente der Wärmetauschereinheit mit Förderleitungen verbunden werden.

Die Nachrüstvorrichtung und das System sollen hierbei nicht auf die oben beschriebene Anwendung und Ausführungsform beschränkt sein. Insbesondere kann die Nachrüstvorrichtung und/oder das System zu einer Erfüllung einer hierin beschriebenen Funktionsweise eine von einer hierin genannten Anzahl von einzelnen Elementen, Bauteilen und Einheiten abweichende Anzahl aufweisen.

### Zeichnungen

Weitere Vorteile ergeben sich aus der folgenden Zeichnungsbeschreibung. In den Zeichnungen sind zwei Ausführungsbeispiele der Erfindung dargestellt. Die Zeichnungen, die Beschreibung und die Ansprüche enthalten zahlreiche Merkmale in Kombination. Der Fachmann wird die Merkmale zweckmässigerweise auch einzeln betrachten und zu sinnvollen weiteren Kombinationen zusammenfassen.

Es zeigen:
- Fig. 1: ein Photovoltaikmodul und eine Nachrüstvorrichtung für das Pho-tovoltaikmodul in einer schematischen Explosionsdarstellung,
- Fig. 2: ein System mit dem Photovoltaikmodul und der Nachrüstvorrichtung und in einer schematischen Schnittdarstellung, wobei die Nachrüstvorrichtung mit dem Photovoltaikmodul verbunden ist,
- Fig. 3: ein schematisches Verfahrensfliessbild zur Darstellung eines Verfahrens zur Montage der Nachrüstvorrichtung an dem Photovoltaikmodul und
- Fig. 4: ein weiteres Ausführungsbeispiel eines Systems mit einem Photovoltaikmodul und einer Nachrüstvorrichtung und in einer schemati-schen Schnittdarstellung, wobei die Nachrüstvorrichtung mit dem Photovoltaikmodul verbunden ist.

### Beschreibung der Ausführungsbeispiele

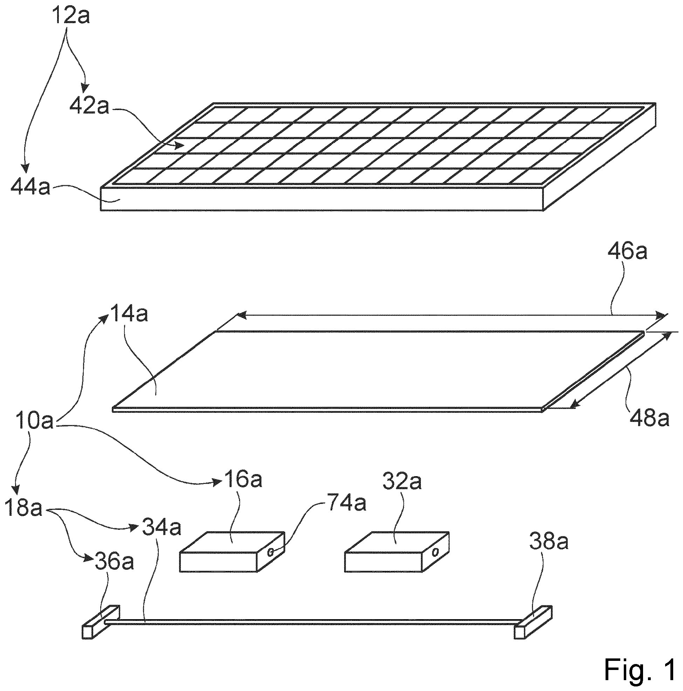

Figur 1 zeigt ein Photovoltaikmodul 12a und eine Nachrüstvorrichtung 10a für das Photovoltaikmodul 12a in einer schematischen Explosionsdarstellung.

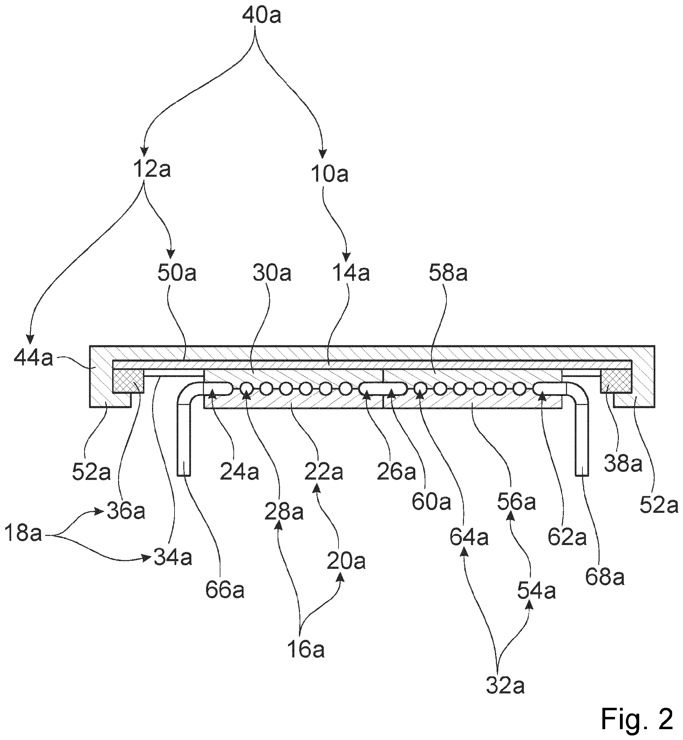

Das Photovoltaikmodul 12a weist eine Vielzahl von Solarzellen 42a und einen Rahmen 44a auf. Die Solarzellen 42a sind in den Rahmen 44a eingefasst und können zur Oberseite durch eine Glasplatte oder eine transparente Folie (nicht dargestellt) abgedeckt sein. Zu einer Unterseite 50a (vgl. Figur 2) hin sind die Solarzellen 42a durch eine Schicht aus Kunststoff (nicht dargestellt), beispielsweise PVC, abgedeckt.

Die Nachrüstvorrichtung 10a weist zumindest ein, vorliegend genau ein, Wärmeübergangselement 14a auf. Das Wärmeübergangselement 14a ist zur Aufnahme und/oder Abgabe von thermischer Energie vorgesehen. Das Wärmeübergangselement ist aus einem Material mit einer hohen Wärmeleitfähigkeit ausgebildet. Vorliegend ist das Wärmeübergangselement 14a beispielsweise als eine Platte aus Kupfer ausgebildet und weist eine Wärmeleitfähigkeit von zumindest 250 W/(m*K) auf.

Die Nachrüstvorrichtung 10a weist zudem zumindest eine Wärmetauschereinheit 16a auf. Vorliegend weist die Nachrüstvorrichtung 10a die Wärmetauschereinheit 16a und eine weitere Wärmetauschereinheit 32a auf. In einem montierten Zustand der Nachrüstvorrichtung 10a (vgl. Figur 2) sind die Wärmetauschereinheit 16a und die weitere Wärmetauschereinheit 32a jeweils mit dem Wärmeübergangselement (14a; 14b) thermisch gekoppelt.

Ferner umfasst die Nachrüstvorrichtung 10a eine Verbindungseinheit 18a. Die Verbindungseinheit 18a ist dazu ausgebildet, das Wärmeübergangselement 14a derart an dem Photovoltaikmodul 12a zu fixieren, dass es zumindest abschnittsweise in einem unmittelbaren Oberflächenkontakt mit einer äusseren Oberfläche des Photovoltaikmoduls 12a steht. Die Verbindungseinheit 18a weist vorliegend ein Verbindungselement 34a, ein erstes Fixierelement 36a und ein zweites Fixierelement 38a auf. Das Verbindungselement 34a ist vorliegend stabförmig ausgebildet. Das Verbindungselement 34a kann beispielsweise als eine Voll- oder Teil-Gewindestange ausgebildet sein. Das erste Fixierelement 36a und das zweite Fixierelement 38a sind vorliegend jeweils quaderförmig ausgebildet. Das erste Fixierelement 36a und das zweite Fixierelement 38a sind zur lösbaren Verbindung an gegenüberliegenden Seiten des Verbindungselements 34a vorgesehen und können beispielsweise mit diesem verschraubt werden.

Das Wärmeübergangselement 14a weist Abmessungen auf, die so gewählt sind, dass das Wärmeübergangselement 14a in einem montierten Zustand (vgl. Figur 2), in welchem es an dem Photovoltaikmodul 12a fixiert ist, zumindest 25 % der äusseren Oberfläche des Photovoltaikmoduls 12a abdeckt. Vorliegend weist das Wärmeübergangselement 14a eine Länge 46a und eine Breite 48a auf, die jeweils so gewählt sind, dass das Wärmeübergangselement 14a in dem montierten Zustand die Unterseite 50a (vgl. Figur 2) des Photovoltaikmoduls 12a zumindest im Wesentlichen abdeckt, sodass in dem montierten Zustand zumindest 45% der äusseren Oberfläche des Photovoltaikmoduls 12a durch das Wärmeübergangselement 14a abgedeckt sind. Das Wärmeübergangselement 14a kann eine Aussparung (nicht dargestellt) aufweisen, um einen Anschlussbereich für elektronische Anschlüsse (nicht dargestellt) des Photovoltaikmoduls 12a freizuhalten.

Figur 2 zeigt ein System 40a mit dem Photovoltaikmodul 12a und der Nachrüstvorrichtung 10a in einer schematischen Schnittdarstellung, wobei die Nachrüstvorrichtung 10a mit dem Photovoltaikmodul 12a verbunden ist.

Die Verbindungseinheit 18a ist zu einer zerstörungsfrei lösbaren, insbesondere form- und/oder kraftschlüssigen, Verbindung mit dem Photovoltaikmodul 12a ausgebildet. Vorliegend ist in dem montierten Zustand das Wärmeübergangselement 14a form- und kraftschlüssig mit dem Photovoltaikmodul 12a verbunden, wobei das Wärmeübergangselement 14a mittels des ersten Fixierelements 36a und des zweiten Fixierelements 38a zwischen der Unterseite 50a des Photovoltaikmoduls 12a und einem Vorsprung 52a, welcher durch den Rahmen 44a des Photovoltaikmoduls 12a ausgebildet ist, eingespannt ist.

Die Wärmetauschereinheit 16a ist mittels der Verbindungseinheit 18a an dem Wärmeübergangselement 14a fixiert. Die Wärmetauschereinheit 16a weist eine Durchgangsbohrung 74a (vgl. Figur 1) auf. In dem montierten Zustand ist das Verbindungselement 34a durch die Durchgangsbohrung 54a der Wärmetauschereinheit 16a hindurchgeführt und mit dem ersten Fixierelement 36a sowie dem zweiten Fixierelement 38a form- und/oder kraftschlüssig verbunden.

Die weitere Wärmetauschereinheit 32a ist zumindest im Wesentlichen identisch zu der Wärmetauschereinheit (16a) ausgebildet und auf gleiche Art und Weise wie die Wärmetauschereinheit 16a ebenfalls mittels der Verbindungseinheit 18a an dem Wärmübergangselement 14a fixiert.

Die Wärmetauschereinheit 16a weist eine Gehäuseeinheit 20a auf. Die Gehäuseeinheit 20a umfasst zumindest ein erstes Gehäuseelement 22a. Die Gehäuseeinheit 20a umfasst ausserdem ein erstes Anschlusselement 24a und zumindest ein zweites Anschlusselement 26a. Ein Strömungskanal 28a der Wärmetauschereinheit 16a für ein Wärmeträgermedium, beispielsweise Wasser, verbindet die Anschlusselemente 24a, 26a strömungstechnisch miteinander. Der Strömungskanal 28a ist zumindest teilweise durch das Gehäuseelement 22a ausgebildet.

In dem vorliegenden Ausführungsbeispiel weist die Gehäuseeinheit 20a ein zweites Gehäuseelement 30a auf. Der Strömungskanal 28a ist durch das Gehäuseelement 22a und das weitere Gehäuseelement 30a begrenzt. Vorliegend sind das erste Anschlusselement 24a und das zweite Anschlusselement 26a auf gegenüberliegenden Seiten der Gehäuseeinheit 20a angeordnet und werden jeweils durch das erste Gehäuseelement 22a und das zweite Gehäuseelement 30a ausgebildet. Alternativ könnte das erste Anschlusselement 24a und/oder das zweite Anschlusselement 26a jedoch auch an der Unterseite des ersten Gehäuseelements angeordnet und ausschliesslich durch dieses ausgebildet sein. In einem montierten Zustand der Wärmetauschereinheit 16a sind das erste Gehäuseelement 22a und das zweite Gehäuseelement 30a miteinander verbunden, beispielsweise verschraubt. Die Wärmetauschereinheit 16a weist zumindest ein Dichtelement (nicht dargestellt), beispielsweise einen O-Ring oder dergleichen auf, welches in dem montierten Zustand zwischen dem ersten Gehäuseelement 22a und dem zweiten Gehäuseelement 30a angeordnet ist, um die Gehäuseeinheit 20a nach aussen hin abzudichten und einen Austritt von Wärmeträgermedium aus der Gehäuseeinheit 20a in Bereichen ausserhalb der Anschlusselemente 24a, 26a zu verhindern.

Der Strömungskanal 28a weist vorliegend einen mäanderförmigen Verlauf und senkrecht zu seinem Verlauf einen konstanten im Wesentlichen kreisförmigen Querschnitt auf. Der Strömungskanal 28a erstreckt sich ausgehend von dem ersten Anschlusselement 24a durch die Gehäuseeinheit 20a hindurch bis zu dem zweiten Anschlusselement 26a. Vorliegend sind das erste Gehäuseelement 22a und das zweite Gehäuseelement 30a spiegelsymmetrisch zueinander ausgebildet und der Strömungskanal 28a ist jeweils zu gleichen Teilen durch das erste Gehäuseelement 22a und das zweite Gehäuseelement 30a begrenzt. Der Strömungskanal 28a könnte jedoch auch einen beliebigen anderen Verlauf sowie einen beliebigen konstanten oder entlang seines Verlaufs veränderlichen Querschnitt aufweisen, ohne den Rahmen der vorliegenden Erfindung zu verlassen. Ebenso erkennt der Fachmann, dass das erste Gehäuseelement 22a und das zweite Gehäuseelement 30a nicht zwangsläufig spiegelsymmetrisch zueinander ausgebildet sein müssen, um die Erfindung ausführen zu können, sondern dass die Gehäuseelemente 22a, 30a auch andere, insbesondere voneinander unterschiedliche, geeignete Formen aufweisen könnten, die in einem montierten Zustand der Wärmetauschereinheit 16a zusammenwirken und den Strömungskanal zu unterschiedlichen Anteilen begrenzen könnten. Zudem könnte das erste Anschlusselement 24a und/oder das zweite Anschlusselement 26a ausschliesslich durch das erste Gehäuseelement 22a oder das zweite Gehäuseelement 30a ausgebildet und/oder ausschliesslich an dem ersten Gehäuseelement 22a oder ausschliesslich an dem zweiten Gehäuseelement 30a angeordnet sein und/oder insgesamt an einer anderen Position angeordnet sein, ohne den Rahmen der vorliegenden Erfindung zu verlassen.

In dem montierten Zustand der Nachrüstvorrichtung 10a steht das zweite Gehäuseelement 30a zur thermischen Kopplung zumindest abschnittsweise in einem unmittelbaren Oberflächenkontakt mit dem Wärmeübergangselement 14a. Die Verbindungseinheit 18a übt in dem montierten Zustand über das Verbindungselement 34a eine Kraft auf das zweite Gehäuseelement 30a aus, sodass dieses an das Wärmeübergangselement 14a angepresst ist und mit diesem zur thermischen Kopplung in dem unmittelbaren Oberflächenkontakt steht.

In dem vorliegenden Ausführungsbeispiel sind die Wärmetauschereinheit 16a und die weitere Wärmetauschereinheit 32a miteinander hydraulisch in Reihe geschaltet. Da die weitere Wärmetauschereinheit 32a zumindest im Wesentlichen identisch zu der Wärmetauschereinheit 16a ausgebildet ist, weist sie eine weitere Gehäuseeinheit 54a mit einem weiteren ersten Gehäuseelement 56a, einem weiteren zweiten Gehäuseelement 58a, einem weiteren ersten Anschlusselement 60a und einem weiteren zweiten Anschlusselement 62a, sowie einen weiteren Strömungskanal 64a für das Wärmeträgermedium auf, welcher die weiteren Anschlusselement 62a, 64a miteinander verbindet und welcher durch das weitere erste Gehäuseelement 54a und das weitere zweite Gehäuseelement 56a begrenzt ist. In dem montierten Zustand der Nachrüstvorrichtung 10a sind die Wärmetauschereinheit 16a und die weitere Wärmetauschereinheit 32a miteinander hydraulisch in Reihe geschaltet, indem das zweite Anschlusselement 26a der Wärmetauschereinheit 16a, beispielsweise über ein Kupplungselement (nicht dargestellt), mit dem weiteren ersten Anschlusselement 60a verbunden ist.

Das System 40a weist vorliegend eine erste Förderleitung 66a für das Wärmeträgermedium und eine zweite Förderleitung 68a für das Wärmeträgermedium auf. Vorliegend ist die erste Förderleitung 66a an das erste Anschlusselement 24a der Wärmetauschereinheit 16a angeschlossen und die zweite Förderleitung 68a ist an das weitere zweite Anschlusselement 62a der weiteren Wärmetauschereinheit 32a angeschlossen.

In einem Betriebszustand des Systems 40a, kann das Wärmeträgermedium über die erste Förderleitung 66a und das erste Anschlusselement 24a in die Wärmetauschereinheit 32a eingespeist werden, den Strömungskanal 28a durchströmen und anschliessend von dem zweiten Anschlusselement 26a über das weitere erste Anschlusselement 60a zur weiteren Wärmetauschereinheit 32a gelangen, den weiteren Strömungskanal 64a durchströmen, von dort zu dem weiteren zweiten Anschlusselement 62a gelangen und über die zweite Förderleitung 68a abgeführt werden. Gleichermassen ist auch ein Betrieb des Systems 40a mit umgekehrter Strömungsrichtung des Wärmeträgermediums von der zweiten Förderleitung 68a bis in die erste Förderleitung 66a denkbar.

Wenn das Wärmeträgermedium in dem Betriebszustand des Systems 40a mit einer ersten Temperatur zugeführt wird, welche niedriger ist als eine Temperatur der Unterseite 50a des Photovoltaikmoduls 12a, wird gemäss dem zweiten Hauptsatz der Thermodynamik thermische Energie von dem Wärmeübergangselement 14a aufgenommen und über das zweite Gehäuseelement 30a und über das weitere zweite Gehäuseelement 58a auf das Wärmeträgermedium übertragen, welches sich beim Durchströmen der Strömungskanäle 28a, 64a aufheizt und das System 40a mit einer gegenüber der ersten Temperatur erhöhten zweiten Temperatur wieder verlässt. Die Nachrüstvorrichtung 10a kann daher zur Kühlung des Photovoltaikmoduls 12a verwendet werden. Durch die Kühlung des Photovoltaikmoduls 12a kann eine höhere Leistungsausbeute der Solarzellen 42a (vgl. Figur 1) und somit ein effizienterer Betrieb des Photovoltaikmoduls 12a erreicht werden. Zugleich kann die Nachrüstvorrichtung 10a zur Gewinnung von thermischer Energie verwendet werden, indem die über das Wärmeträgermedium von dem Photovoltaikmodul 12a abgeführte thermische Energie weiter genutzt wird. In diesem Zusammenhang ist beispielsweise die Verwendung des Systems 40a zur Warmwasser- und/oder Heizwasserbereitung mittels thermischer Energie, welche durch die Nachrüstvorrichtung 10a gewonnen wird, möglich. Das System 40a kann hierzu über die erste Förderleitung 66a und/oder die zweite Förderleitung 68a beispielsweise mit einem Warmwasserspeicher (nicht dargestellt) und/oder mit einer Heizungsanlage (nicht dargestellt) und/oder mit einer Wärmepumpe (nicht dargestellt) und/oder dergleichen verbunden werden. Alternativ oder zusätzlich ist auch eine Verwendung des Systems 40a zur elektrischen Energieerzeugung mittels eines Teils oder der gesamten thermischer Energie, welche durch die Nachrüstvorrichtung 10a gewonnen wird, möglich. Hierzu kann das System 40a beispielsweise mit einer Turbine (nicht dargestellt) verbunden werden, welche die in dem Wärmeträgermedium enthaltene thermische Energie wenigstens teilweise in Bewegungsenergie zum Antrieb eines Generators (nicht dargestellt) umwandelt. Insbesondere in diesem Zusammenhang ist neben Wasser auch ein Einsatz anderer Wärmeträgermedien zum Betrieb des Systems 40a denkbar, welche beispielsweise einen niedrigeren Siedepunkt als Wasser aufweisen können und beim Durchströmen der Wärmetauschereinheit 16a, 32a zumindest teilweise oder vollständig verdampfen.

Neben diesen Anwendungen kann die Nachrüstvorrichtung 10a auch zur Beheizung des Photovoltaikmoduls 12a verwendet werden. Wenn das Wärmeträgermedium in dem Betriebszustand des Systems 40a mit einer ersten Temperatur zugeführt wird, welche höher ist als eine Temperatur der Unterseite 50a des Photovoltaikmoduls 12a, wird gemäss dem zweiten Hauptsatz der Thermodynamik thermische Energie von dem Wärmeträgermedium über das zweite Gehäuseelement 30a und das weitere zweite Gehäuseelement 58a auf das Wärmeübergangselement 14a übertragen, welches diese wiederum an das Photovoltaikmodul 12a abgibt. Eine Beheizung des Photovoltaikmoduls 12a erweist sich insbesondere bei kalten Aussentemperaturen als zweckmässig. Beispielsweise kann das Photovoltaikmodul 12a im Winter durch eine Schnee- und/oder Eisschicht bedeckt sein und mittels der Nachrüstvorrichtung 10a abgetaut werden, damit die auch im Winter Sonnenstrahlen auf die Solarzellen 42a (vgl. Figur 1) eintreffen und die zur Verfügung stehende Sonnenenergie gut genutzt werden kann. Zur Beheizung des Photovoltaikmoduls 12a kann das System 40a mit einer Wärmequelle, beispielsweise einer Heizungsanlage (nicht dargestellt) oder einer Wärmepumpe (nicht dargestellt) oder dergleichen verbunden werden, welche das Wärmeträgermedium vor Einspeisung in das System 40a auf die erforderliche Temperatur aufheizt.

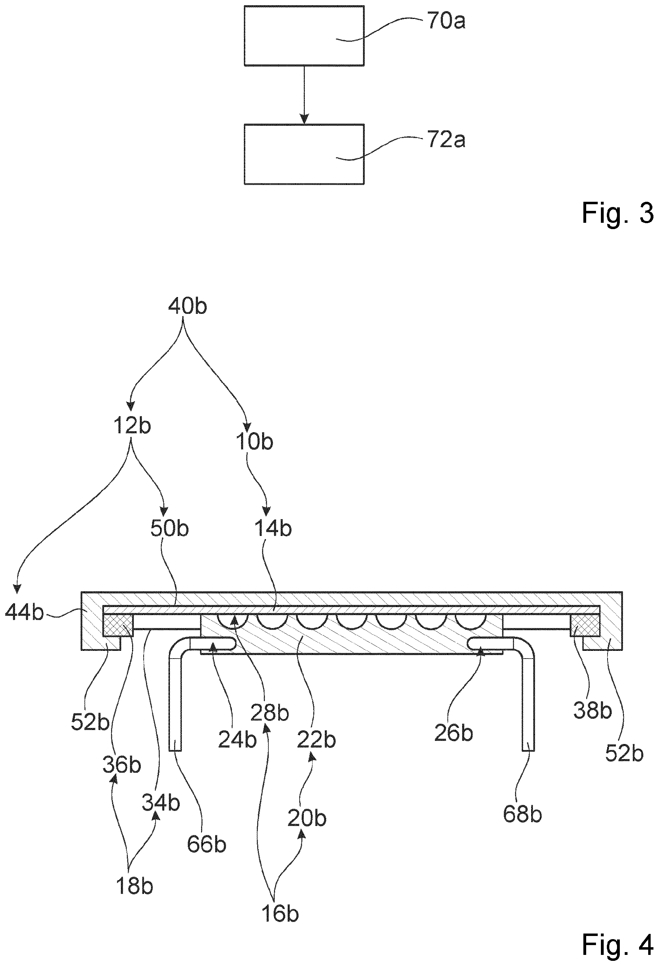

Figur 3 zeigt ein schematisches Verfahrensfliessbild eines Verfahrens zur Montage der Nachrüstvorrichtung 10a. Das Verfahren umfasst zumindest zwei Verfahrensschritte 70a, 72a. In einem ersten Verfahrensschritt 70a des Verfahrens wird das Wärmeübergangselement 14a derart an dem Photovoltaikmodul 12a fixiert, dass es zumindest abschnittsweise in einem unmittelbaren Oberflächenkontakt mit der äusseren Oberfläche des Photovoltaikmoduls 12a, vorzugsweise mit der Unterseite 50a des Photovoltaikmoduls 12a (vgl. Figur 2), steht. Hierzu kann das Wärmeübergangselement 14a mittels des ersten Fixierelements 36a und mittels des zweiten Fixierelements 38a zwischen der Unterseite 50a des Photovoltaikmoduls 12a und dem Vorsprung 52a des Rahmens 44a des Photovoltaikmoduls 12a eingespannt werden. In einem zweiten Verfahrensschritt 72a des Verfahrens wird die Wärmetauschereinheit 16a mit dem Wärmeübergangselement 14a thermisch gekoppelt. Hierzu wird das Verbindungselement 34a durch die Durchgangsbohrung 74a (vgl. Figur 1) hindurchgeführt, an seinem ersten Ende mit dem ersten Fixierelement 36a und an seinem zweiten Ende mit dem zweiten Fixierelement 38a verbunden, beispielsweise verschraubt. Gleichermassen kann in dem zweiten Verfahrensschritt 72a auch die zweite Wärmetauschereinheit 32a mit dem Wärmeübergangselement 14a thermisch gekoppelt werden.

In Figur 4 ist ein zweites Ausführungsbeispiel der Erfindung gezeigt. Die nachfolgenden Beschreibungen beschränken sich im Wesentlichen auf die Unterschiede zwischen den Ausführungsbeispielen, wobei bezüglich gleichbleibender Bauteile, Merkmale und Funktionen auf die obige Beschreibung zu dem ersten Ausführungsbeispiel der Figuren 1 bis 3 verwiesen werden kann. Zur Unterscheidung tragen die Bezugszeichen des ersten Ausführungsbeispiels den Buchstaben a und die Bezugszeichen des zweiten Ausführungsbeispiels den Buchstaben b.

Figur 4 zeigt ein System 40b mit einem Photovoltaikmodul 12b und einer Nachrüstvorrichtung 10b in einer schematischen Schnittdarstellung, wobei die Nachrüstvorrichtung 10b mit dem Photovoltaikmodul 12b verbunden ist.

Analog zu der Nachrüstvorrichtung 10a des ersten Ausführungsbeispiels weist die Nachrüstvorrichtung 10b zumindest ein Wärmeübergangselement 14b zur Aufnahme und/oder Abgabe von thermischer Energie auf. Ebenso weist die Nachrüstvorrichtung 10b zumindest eine Wärmetauschereinheit 16b auf, welche mit dem Wärmeübergangselement 14b thermisch gekoppelt ist. Die Nachrüstvorrichtung 10b umfasst auch eine Verbindungseinheit 18b, die dazu ausgebildet ist, das Wärmeübergangselement 14b derart an dem Photovoltaikmodul 12b zu fixieren, dass es zumindest abschnittsweise in einem unmittelbaren Oberflächenkontakt mit einer äusseren Oberfläche des Photovoltaikmoduls 12b steht.

Hinsichtlich eines Aufbaus und einer Funktionsweise des Wärmeübergangselements 14b sowie der Verbindungseinheit 18b der Nachrüstvorrichtung 10b kann auf die entsprechenden obigen Ausführungen zu dem ersten Ausführungsbeispiel verwiesen werden. Die Nachrüstvorrichtung 10b des vorliegenden Ausführungsbeispiels unterscheidet sich von der Nachrüstvorrichtung 10a des ersten Ausführungsbeispiels im Wesentlichen hinsichtlich einer Ausgestaltung der Wärmetauschereinheit 16b.

Analog zu dem ersten Ausführungsbeispiel weist die Wärmetauschereinheit 16b eine Gehäuseeinheit 20b auf, welche zumindest ein erstes Gehäuseelement 22b, ein erstes Anschlusselement 24b und zweites Anschlusselement 26b umfasst. Ferner weist die Wärmetauschereinheit 16b wiederum einen Strömungskanal für ein Wärmeträgermedium auf, welcher die Anschlusselemente 24b, 26b strömungstechnisch miteinander verbindet und welcher zumindest teilweise durch das erste Gehäuseelement 22b ausgebildet ist. Im Unterschied zu dem vorhergehenden Ausführungsbeispiel weist die Gehäuseeinheit 20b der Wärmetauschereinheit 16b genau ein Gehäuseelement und zwar das erste Gehäuseelement 22b auf.

Der Strömungskanal 28b der Wärmetauschereinheit 16b ist durch das Gehäuseelement 22b und das Wärmübergangselement 14b begrenzt.

Die Wärmetauschereinheit 16b ist wiederum mittels der Verbindungseinheit 18b an dem Wärmeübergangselement 14b fixiert, wobei im Unterschied zu dem ersten Ausführungsbeispiel der Strömungskanal 28b teilweise durch das Wärmeübergangselement 14a ausgebildet ist, sodass in einem Betriebszustand des Systems 40b das Wärmeträgermedium, welches den Strömungskanal 28b durchströmt in direktem Kontakt mit dem Wärmeübergangselement 14b steht. Zwischen dem ersten Gehäuseelement 22b und dem Wärmübergangselement 14b ist vorzugsweise ein Dichtelement (nicht dargestellt), beispielsweise ein O-Ring oder dergleichen, angeordnet, um einen Austritt von Wärmeträgermedium aus der Wärmetauschereinheit 16b ausserhalb der Bereiche der Anschlusselemente 24b, 26b zu vermeiden. Alternativ wäre im Rahmen der vorliegenden Erfindung auch denkbar, das erste Gehäuseelement 22b stoffschlüssig und fluiddicht mit dem Wärmeübergangselement 14b zu verbinden, beispielsweise zu verkleben oder zu verschweissen.

In Figur 4 ist die Nachrüstvorrichtung 10b nur mit der Wärmetauschereinheit 16b gezeigt. Gleichwohl könnte auch die Nachrüstvorrichtung 10b analog zur Nachrüstvorrichtung 10a zumindest eine weitere Wärmetauschereinheit (nicht dargestellt) aufweisen, welche beispielsweise mit der Wärmetauschereinheit 16b hydraulisch in Reihe geschaltet sein könnte.

### Bezugszeichen

- 10: Nachrüstvorrichtung
- 12: Photovoltaikmodul
- 14: Wärmeübergangselement
- 16: Wärmetauschereinheit
- 18: Verbindungseinheit
- 20: Gehäuseeinheit
- 22: erstes Gehäuseelement
- 24: erstes Anschlusselement
- 26: zweites Anschlusselement
- 28: Strömungskanal
- 30: zweites Gehäuseelement
- 32: weitere Wärmetauschereinheit
- 34: Verbindungselement
- 36: erstes Fixierelement
- 38: zweites Fixierelement
- 40: System
- 42: Solarzellen
- 44: Rahmen
- 46: Länge
- 48: Breite
- 50: Unterseite
- 52: Vorsprung
- 54: weitere Gehäuseeinheit
- 56: weiteres erstes Gehäuseelement
- 58: weiteres zweites Gehäuseelement
- 60: weiteres erstes Anschlusselement
- 62: weiteres zweites Anschlusselement
- 64: weiterer Strömungskanal
- 66: erste Förderleitung
- 68: zweite Förderleitung
- 70: erster Verfahrensschritt
- 72: zweiter Verfahrensschritt
- 74: Durchgangsbohrung

## Patentansprüche

1. Nachrüstvorrichtung (10a; 10b) für ein Photovoltaikmodul (12a; 12b), mit zumindest einem Wärmeübergangselement (14a; 14b) zur Aufnahme und/oder Abgabe von thermischer Energie, mit zumindest einer Wärmetauschereinheit (16a; 16b), welche mit dem Wärmeübergangselement (14a; 14b) thermisch gekoppelt ist, und mit einer Verbindungseinheit (18a; 18b) zur Verbindung mit dem Photovoltaikmodul (12a; 12b), wobei die Verbindungseinheit (18a; 18b) dazu ausgebildet ist, das Wärmeübergangselement (14a; 14b) derart an dem Photovoltaikmodul (12a; 12b) zu fixieren, dass es zumindest abschnittsweise in einem unmittelbaren Oberflächenkontakt mit einer äusseren Oberfläche des Photovoltaikmoduls (12a; 12b) steht.

2. Nachrüstvorrichtung (10a; 10b) nach Anspruch 1, **dadurch gekennzeichnet, dass** die Verbindungseinheit (18a; 18b) zu einer zerstörungsfrei lösbaren, insbesondere form- und/oder kraftschlüssigen, Verbindung mit dem Photovoltaikmodul (12a; 12b) ausgebildet ist.

3. Nachrüstvorrichtung (10; 10b) nach Anspruch 1 oder 2, **dadurch gekennzeichnet, dass** das Wärmeübergangselement (14a; 14b) Abmessungen aufweist, die so gewählt sind, dass das Wärmeübergangselement (14a; 14b) in einem montierten Zustand, in welchem es an dem Photovoltaikmodul (12a; 12b) fixiert ist, zumindest 25 % der äusseren Oberfläche des Photovoltaikmoduls (12a; 12b) abdeckt.

4. Nachrüstvorrichtung (10a; 10b) nach einem der vorhergehenden Ansprüche, **dadurch gekennzeichnet, dass** die Wärmetauschereinheit (16a; 16b) mittels der Verbindungseinheit (18a; 18b) an dem Wärmeübergangselement (14a; 14b) fixiert ist.

5. Nachrüstvorrichtung (10a; 10b) nach einem der vorhergehenden Ansprüche, **dadurch gekennzeichnet, dass** die Wärmetauschereinheit (16a; 16b) eine Gehäuseeinheit (20a; 20b) aufweist, welche zumindest ein erstes Gehäuseelement (22a; 22b), ein erstes Anschlusselement (24a; 24b) und zumindest ein zweites Anschlusselement (26a; 26b) umfasst, wobei ein Strömungskanal (28a; 28b) für ein Wärmeträgermedium, welcher die Anschlusselemente (24a, 26a; 24b, 26b) strömungstechnisch miteinander verbindet, zumindest teilweise durch das erste Gehäuseelement (22a; 22b) ausgebildet ist.

6. Nachrüstvorrichtung (10a) nach Anspruch 5, **dadurch gekennzeichnet, dass** die Gehäuseeinheit (20a) ein zweites Gehäuseelement (30a) aufweist, wobei der Strömungskanal (28a) durch das erste Gehäuseelement (22a) und das zweite Gehäuseelement (30a) begrenzt ist und das zweite Gehäuseelement (30a) zur thermischen Kopplung zumindest abschnittsweise in einem unmittelbaren Oberflächenkontakt mit dem Wärmeübergangselement (14a) steht.

7. Nachrüstvorrichtung (10b) nach Anspruch 5, **dadurch gekennzeichnet, dass** der Strömungskanal (28b) durch das erste Gehäuseelement (22b) und das Wärmübergangselement (14b) begrenzt ist.

8. Nachrüstvorrichtung (10a; 10b) nach einem der vorhergehenden Ansprüche, **gekennzeichnet durch** eine weitere Wärmetauschereinheit (32a), welche zumindest im Wesentlichen identisch zu der Wärmetauschereinheit (16a) ausgebildet und mit dem Wärmeübergangselement (14a) thermisch gekoppelt ist.

9. Nachrüstvorrichtung (10a) nach Anspruch 8, **dadurch gekennzeichnet, dass** die Wärmetauschereinheit (16a) und die weitere Wärmetauschereinheit (32a) miteinander hydraulisch in Reihe geschaltet sind.

10. Verwendung einer Nachrüstvorrichtung (10a; 10b) nach einem der vorhergehenden Ansprüche zur Kühlung eines Photovoltaikmoduls (12a; 12b) und zur Gewinnung von thermischer Energie.

11. Verwendung einer Nachrüstvorrichtung (10a; 10b) nach einem der Ansprüche 1 bis 9 zur Beheizung eines Photovoltaikmoduls (12a; 12b).

12. System (40a; 40b) mit zumindest einem Photovoltaikmodul (12a; 12b) und zumindest einer Nachrüstvorrichtung (10a; 10b) nach einem der Ansprüche 1 bis 9, wobei die Nachrüstvorrichtung (10a; 10b) mit dem Photovoltaikmodul (12a; 12b) verbunden ist.

13. Verwendung eines Systems (40a; 40b) nach Anspruch 12 zur Warmwasser- und/oder Heizwasserbereitung mittels thermischer Energie, welche durch die Nachrüstvorrichtung (10a; 10b) gewonnen wird.

14. Verwendung eines Systems (40a; 40b) nach Anspruch 12 zur elektrischen Energieerzeugung mittels thermischer Energie, welche durch die Nachrüstvorrichtung (10a; 10b) gewonnen wird.

15. Verfahren zur Montage einer Nachrüstvorrichtung (10a; 10b), insbesondere nach einem der Ansprüche 1 bis 9, an einem Photovoltaikmodul (12a; 12b), wobei zumindest ein Wärmeübergangselement (14a; 14b) zur Aufnahme und/oder Abgabe von thermischer Energie derart an dem Photovoltaikmodul (12a; 12b) fixiert wird, dass das Wärmeübergangselement (14a; 14b) zumindest abschnittsweise in einem unmittelbaren Oberflächenkontakt mit einer äusseren Oberfläche des Photovoltaikmoduls (12a; 12b) steht und wobei zumindest eine Wärmetauschereinheit (16a; 16b) mit dem Wärmeübergangselement (14a; 14b) thermisch gekoppelt wird.
